# EUROPÄISCHE PATENTSCHRIFT

(11) **EP 3 550 748 B1**
(45) Veröffentlichungstag und Bekanntmachung des Hinweises auf die Patenterteilung: **11.08.2021**
(21) Anmeldenummer: 18165818.8
(22) Anmeldetag: 05.04.2018
(51) Int. Cl.: H04L 1/00

(54) **VERFAHREN ZUR ERKENNUNG VON DATENVERFÄLSCHUNGEN BEI EINER DATENÜBERTRAGUNG ÜBER EINE FEHLERSICHERE KOMMUNIKATIONSVERBINDUNG**
METHOD FOR DETECTING DATA FALSIFICATION IN A DATA TRANSFER OVER ERROR-PROOF COMMUNICATION LINK
PROCÉDÉ DE DÉTECTION DES CONTAMINATIONS DES DONNÉES LORS D'UNE TRANSMISSION DE DONNÉES À L'AIDE D'UNE LIAISON DE COMMUNICATION SÉCURISÉE

(43) Veröffentlichungstag der Anmeldung: 09.10.2019
(73) Patentinhaber: Siemens Aktiengesellschaft, 80333 München (DE)
(72) Erfinder: Gjerkes, Ales, 9232 Crensovci (SI); Hubert, Johannes, 90559 Burgthann (DE); Lorentschk, Marcus, 90763 Fürth (DE); Meyer, Thomas Markus, 90475 Nürnberg (DE); Michaelis, Nico, 90768 Fürth (DE); Scherr, Christoph, 8081 Heiligen Kreuz am Waasen (AT); Watzenig, Reinhard, 8511 St. Stefan ob Stainz (AT)

(56) Entgegenhaltungen:
- EP-A2- 2 634 129
- "Industrial communication networks - Profiles - Part 3-12: Functional safety fieldbuses - Additional specifications for CPF 12", IEC 61784-3-12:2010, IEC, 3, RUE DE VAREMBÉ, PO BOX 131, CH-1211 GENEVA 20, SWITZERLAND, 29. Juni 2010 (2010-06-29), Seiten 1-203, XP082006973, [gefunden am 2010-06-29]
- PROFIBUS NUTZERORGANISATION E V PNO ED - PROFIBUS NUTZERORGANISATION E V PNO: "PROFIsafe Systembeschreibung Technologie und Anwendung", INTERNET CITATION, November 2010 (2010-11), Seiten 1-26, XP002657152, Gefunden im Internet: URL:http://www.profibus.com/nc/downloads/d ownloads/profisafe-technology-and-applicat ion-system-description/downloads/9595 [gefunden am 2011-08-18]

## Beschreibung

Die Erfindung betrifft ein Verfahren zur Erkennung von Datenverfälschungen bei einer Datenübertragung über eine fehlersichere Kommunikationsverbindung zwischen einer ersten Automatisierungskomponente und einer zweiten Automatisierungskomponente der industriellen Steuerungstechnik, wobei bei einer Übertragung einer Datenstruktur zur Absicherung der Datenstruktur in einem zu übertragenen Telegramm sowohl auf der Seite der ersten Automatisierungskomponente als auch auf der Seite der zweiten Automatisierungskomponente eine Checksumme über das Telegramm gebildet wird, die Datenstruktur umfasst dabei unterschiedliche Datentypen.

Die Erfindung betrifft das technische Gebiet der fehlersicheren Kommunikation, die u.a. die Kommunikation zwischen Feldgeräten, Steuerungskomponenten und ähnlichen Einrichtungen in der industriellen Prozessautomatisierung oder Fertigungsautomatisierung eingesetzt wird. Eine solche fehlersichere Kommunikation wird auch F-Kommunikation genannt, insbesondere bei sicherheitsrelevanten Anwendungen, insbesondere dann, wenn Fehler in der Kommunikation zur Gefährdung von Menschen, Tieren oder Sachwerten führen können.

Zur fehlersicheren Kommunikation in den oben genannten technischen Gebieten wird im Stand der Technik eine besonders abgesicherte paketvermittelte Datenübertragung eingesetzt, insbesondere das Profisafe-Protokoll.

In der EP 2 814 193 B1 ist ein Verfahren zur Erkennung von Fehlern bei der Übertragung von Daten von einem Sender zu zumindest einem Empfänger beschrieben.

Die Profisafe Norm V2.6.1 Norm der PNO 2014 beschreibt auf Seite 81, ab Zeile 1999, wie mittels einer Checksumme Datenstrukturen abgesichert werden. Im fehlersicheren Umfeld sind bei Kommunikationen zwischen fehlersicheren Controllern oder zu fehlersicheren I/O-Modulen gesonderte Fehlerbetrachtungen durchzuführen. Diese Fehlerbetrachtungen betreffen, insbesondere die Absicherung, dass der gewünschte Verbindungspartner korrekt adressiert wurde und auch die Konfiguration auf beiden Kommunikationspartnern zusammenpasst. Dies betrifft u.a. auch die Datenstruktur beider Kommunikationspartner. Tritt hierbei ein Fehler auf, müssen diese Fehler sicher erkannt werden und die fehlersichere Kommunikation einen sicheren Zustand einnehmen. Beim Erkennen eines Fehlers kann z.B. der Empfänger der den Fehler erkannt hat, für Ersatzwerte sorgen und diese an den Prozess ausgeben.

Die Veröffentlichung "Industrial communication networks - Profiles - Part 3-12: Functional safety fieldbuses - Additional specifications for CPF 12" zeigt bereits die Kontrolle von Datenpaketen im industriellen Einsatz unter Verwendung von Checksummen. Bezüglich der Patentansprüche ist zur Abstellung der Klarheit Einwände

In der Profisafe Norm V2.6.1 sind bereits alle Fehlerbetrachtungen abgehandelt worden, aber von Nachteil ist es, dass wenn Fehler in einer Datenstruktur auftreten, diese nicht sicher erkannt werden können.

Aufgabe der Erfindung ist es daher ein Verfahren bereitzustellen, mit welchem es möglich ist, einen Datenübertragungsfehler aufzudecken, bei welchem ein Empfänger und ein Sender eine unterschiedliche Datenstruktur haben.

Bei dem eingangs genannten Verfahren zur Erkennung von Datenverfälschungen wird die Aufgabe dadurch gelöst, dass vor dem Bilden der Checksumme für das Telegramm auf der Seite der ersten Automatisierungskomponente den in der Datenstruktur enthaltenen Datentypen ein datenspezifischer Repräsentant zugeordnet wird, und anschließend über die eine Repräsentanten Struktur-Checksumme gebildet wird, und dann die Datenstruktur mit der über die Repräsentanten gebildeten Struktur-Checksumme übertragen wird, wobei bei der zweiten Automatisierungskomponente über den in der empfangenen Datenstruktur enthaltenen Datentypen erneut der datenspezifische Repräsentant zugeordnet wird, und erneut über die Repräsentanten eine erneute Struktur-Checksumme gebildet wird, die übertragene und die erneut berechnete Struktur-Checksumme wird auf der Seite der zweiten Automatisierungskomponente geprüft und bei einer Abweichung der Struktur-Checksummen voneinander wird eine Datenverfälschung erkannt.

Im Sinne der Erfindung ist ein Repräsentant mathematisch zu sehen und demnach ein Element einer bestimmten Art. Der entscheidende Vorteil ist nun das eine frühere unentdeckte Tauschung der Datentypen innerhalb der Datenstruktur nun erkannt werden kann.

In einer vorteilhaften Weiterbildung des Verfahrens wird bei einer erkannten Datenverfälschung ein Datenübertragungsfehler in der Kommunikationsverbindung erkannt und für die Kommunikationsverbindung wird ein sicherer Zustand gewählt, wobei vorprojektierte Ersatzwerte in der zweiten Automatisierungskomponente bereitgestellt werden.

Um eine zyklische Struktur-Checksumme für die Datenstruktur innerhalb des normalen Telegramms einzubinden ist es von Vorteil, wenn bei der Datenübertragung die über die Repräsentanten gebildete Struktur-Checksumme zusätzlich zu einer über das zu übertragende Telegramm gebildeten Checksumme übertragen wird.

Es ist von Vorteil, wenn als Repräsentant ein numerischer Bezeichner, ein textueller Bezeichner oder auch der Datentypbezeichner verwendet wird.

Zur Datenübertragung wird vorzugsweise ein Sicherheitsprotokoll, insbesondere das Profisafe-Protokoll, verwendet.

Mit besonderem Vorteil werden als Datenstrukturen die Datenstrukturen gemäß der Spezifikation OPC UA gewählt.

Die eingangs genannte Aufgabe wird ebenfalls durch ein Engineering-System zum Anlegen und/oder Konfigurieren und/oder Überwachen einer fehlersicheren Kommunikationsverbindung zwischen einer ersten Automatisierungskomponente und einer zweiten Automatisierungskomponente gelöst. Die Automatisierungskomponenten befinden sich in einer Automatisierungsanlage der industriellen Steuerungstechnik, wobei über die Kommunikationsverbindung auch Datenstrukturen, übertragbar sind. Die Datenstrukturen umfassen dabei unterschiedliche Datentypen und erfindungsgemäß ist nun ein Zuordnungsmittel vorhanden, welches ausgelegt ist, den Datentypen einer Datenstruktur, welche einer angelegten fehlersicheren Kommunikationsverbindung zugeordnet ist, jeweils einen datentypenspezifischen Repräsentanten zuzuordnen und diese Zuordnung als Zuordnungsinformation der ersten und zweiten Automatisierungskomponente zu übergeben, welcher zur Erkennung einer Datenverfälschung bei einer Datenübertragung über die fehlersichere Kommunikationsverbindung zwischen der ersten Automatisierungskomponente und der zweiten Automatisierungskomponente über die Repräsentanten eine Struktur-Checksumme bilden.

Zur Absicherung von Datenstrukturen bei einer fehlersicheren Kommunikation wird nun auf beiden Seiten eine Struktur-Checksumme (z.B. CRC, Hash) über die Datenstruktur gebildet und durch die Verbindungspartner geprüft. Die Struktur-Checksumme berücksichtigt dabei den Datentyp sowie die Reihenfolge der Daten in der Datenstruktur. Dabei kann die Repräsentation eines Datentypes z.B. durch nummerische Bezeichner, durch textuelle Bezeichner (repräsentativer Bezeichner oder auch Datentypbezeichner selbst) oder auch alphanumerisch erfolgen. Entscheidend dabei ist, dass jeder Datentyp eindeutig referenziert werden kann. Um die Struktur-Checksumme zu berechnen, wird in der Reihenfolge in der die Datentypen in der Verbindung angelegt werden, auf die Repräsentation gemapt und darüber die Checksumme gebildet.

Vorteilhafter Weise wird in einem Engineering-System nach Erkennen einer Datenverfälschung durch die Automatisierungskomponente ein Eintrag in einem Diagnosepuffer veranlasst. Vorzugsweise trägt die Automatisierungskomponente, ausgestaltet als eine SPS, den erkannten Fehler in einen Fehlerspeicher ein und das Engineeringsystem kann diesen abfragen.

Die Zeichnung beschreibt ein Ausführungsbeispiel der Erfindung. Es zeigt:
- FIG 1: eine grundsätzliche Mappingtabelle oder Zuordnungstabelle mit Datentypen und drei Beispielen für Datenstrukturen,
- FIG 2: eine Datenübertragung von einem Sender zu einem Empfänger nach dem Stand der Technik (fehlerfrei),
- FIG 3: eine Datenübertragung zwischen einem Sender und Empfänger nach dem Stand der Technik (mit Datenverfälschung unerkannt),
- FIG 4: eine Datenübertragung zwischen einem Sender und einem Empfänger mit einer zusätzlichen Struktur-Checksumme über die Datentypen der Datenstruktur und
- FIG 5: eine Automatisierungsanlage mit einer fehlersicheren Kommunikationsverbindung zwischen zwei Automatisierungskomponenten.

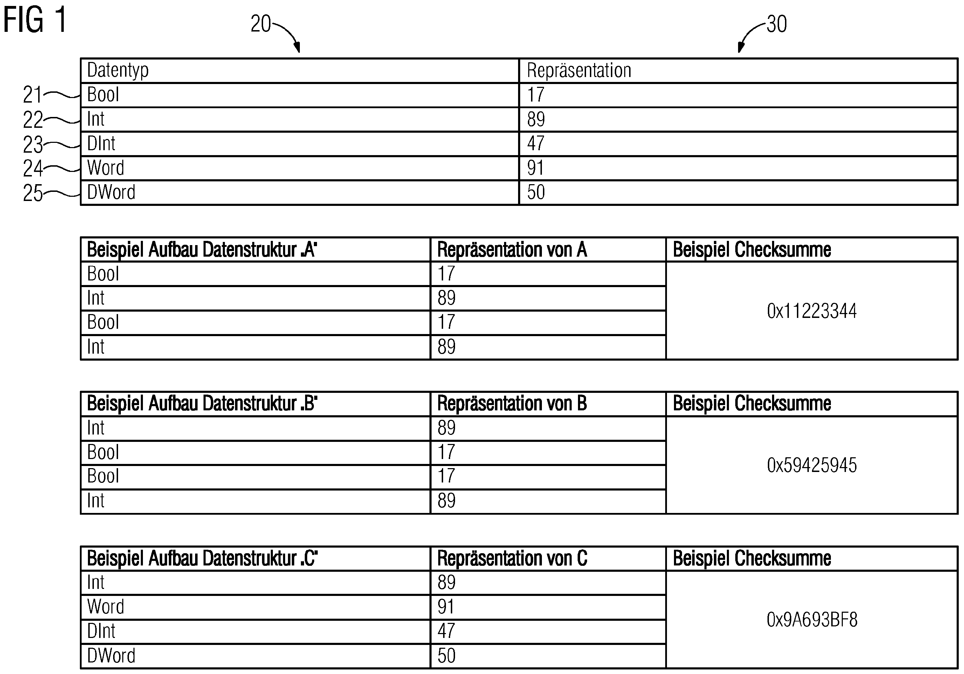

Gemäß FIG 1 ist eine Mappingtabelle für eine Datenstruktur 20 mit einem ersten Datentyp 21, einem zweiten Datentyp 22, einem dritten Datentyp 23, einem vierten Datentyp 24 und einem fünften Datentyp 25 dargestellt. Die Datenstruktur 20 umfasst demnach fünf Strukturelemente (Bool, Int, DInt, Word, DWord).

Jedem der Datentypen 21,...,25 ist eindeutig ein Repräsentant 30 zugeordnet. Der Datentyp Bool hat den Repräsentanten 17, der Datentyp Int hat den Repräsentanten 89, der Datentyp DInt hat den Repräsentanten 47, der Datentyp Word hat den Repräsentanten 91 und der Datentyp DWord hat den Repräsentanten 50.

Die Datenstruktur A ist beispielsweise aus vier Datentypen aufgebaut und hat die Reihenfolge Bool, Int, Bool, Int, dementsprechend sind den Datentypen Bool die Repräsentanten 17 und den Datentypen Int die Repräsentanten 89 zugeordnet. Bildet man nun über die Reihenfolge der Repräsentanten 17, 89, 17, 89 die Checksumme so erhält man für die Datenstruktur Beispiel A eine spezifische Checksumme 0X11223344.

Die Datenstruktur B hat Datentypen in der Reihenfolge Int, Bool, Bool, Int und hat dementsprechend die Repräsentanten 89, 17, 17, 89 eine beispielhafte Checksumme über die Reihenfolge der Repräsentanten 89,17,17,89 ergäbe, eine Checksumme von 0X59425945.

Die Datenstruktur C weist ebenfalls vier Datentypen auf, und hat diesmal die Datentypen Int, Word, DInt, DWord dementsprechend die Repräsentanten 89, 91, 47, 50 zugeordnet und es ergibt sich eine beispielhafte Checksumme von 0X9A693BF8.

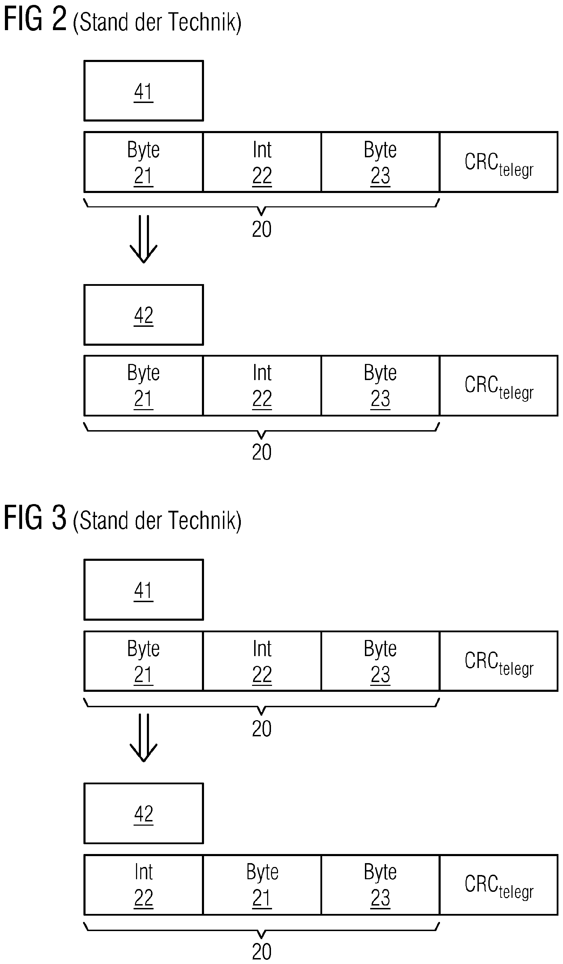

Mit der FIG 2 ist eine Datenübertragung einer Datenstruktur 20 zwischen einem Sender 41 und einem Empfänger 42 nach dem Stand der Technik dargestellt. Es wird eine Datenstruktur 20 mit drei Datentypen 21,22,23 übertragen. Zur Übertragungssicherung wird nach dem Stand der Technik über das ganze Telegramm inklusive der Datenstruktur 20 eine Checksumme CRCtelegr gebildet. Das Telegramm mit der Datenstruktur 20 und der Checksumme CRC_{telegr} wird zum Empfänger 42 übertragen und kommt in einem Gutfall so an, wie es abgesendet worden ist. Die Checksumme CRC_{telegr} wurde über das Telegramm mit einem Startwert der z.B. die Adresssicherungsinformation enthält gebildet und wenn beide, Empfänger und Sender, die gleiche Interpretation der Daten haben, so ist ein Übertragungsfehler ausgeschlossen.

Mit der FIG 3 wird ein Datenübertragungsfehler nach dem Stand der Technik dargestellt. Der Sender 41 übermittelt wiederum zu dem Empfänger 42 die bereits mit FIG 2 gezeigte Datenstruktur 20. Nun hat sich aber bei der Übertragung von Sender 41 zu Empfänger 42 ein Fehler eingeschlichen und zwar ist die Reihenfolge der Datentypen in der Datenstruktur 20 durcheinander geraden. Es wird aber nach wie vor nach dem Stand der Technik über die gesamte Datenstruktur eine Checksumme CRCtelegr gebildet. Daraus folgt das der Empfänger 42 und der Sender 41 eine unentdeckte unterschiedliche Interpretation der Daten in der Datenstruktur haben. Aber dennoch wird das Telegramm als gültiges Telegramm vom Empfänger angesehen.

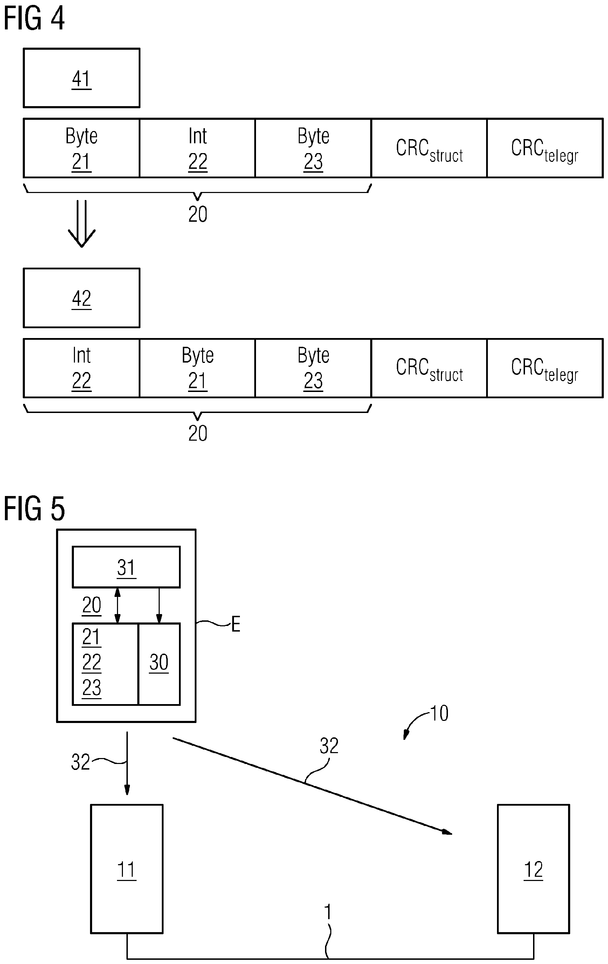

Gemäß FIG 4 werden nun erfindungsgemäß zu einer Datenstruktur 20 eine zusätzliche Struktur-Checksumme CRC_{struct} gebildet. Die zusätzliche Struktur-Checksumme CRC_{struct} wird über datenspezifische Repräsentanten 30 für den ersten Datentyp 21, den zweiten Datentyp 22 und den dritten Datentyp 23 gebildet. Dementsprechend wird über die Zahlenfolge 17, 89, 17 die Struktur-Checksumme CRC_{struct} gebildet. Das bedeutet, dass vor dem Bilden der Checksumme CRC_{telegr} für das Telegramm auf der Seite der ersten Automatisierungskomponente 11 dem in der Datenstruktur 20 enthaltenen Datentypen 21,22,23 ein datenspezifischer Repräsentant 30 zugeordnet wird, und anschließend über die Repräsentanten 30 die Struktur-Checksumme CRCstruct gebildet wird und dann wird die Datenstruktur 20 mit der über die Repräsentanten 30 gebildeten Struktur-Checksumme CRC_{struct} übertragen, wobei zusätzlich die normale Checksumme CRC_{telegr} des Telegramms wieder angehängt wird. Eine andere Möglichkeit wäre auch, dass die Checksumme CRC_{struct} der Datenstruktur als Startwert mit in die Checksumme CRC_{telegr} des Telegramms mit eingeht. Kommt dieses Telegramm bei der zweiten Automatisierungskomponente 12 bzw. beim Empfänger 42 an, so wird den in der empfangenen Datenstruktur 20 enthaltenen Datentypen 21,22,23 erneut der datentypspezifische Repräsentant 30 zugeordnet und erneut über die Repräsentanten 30 die Struktur-Checksumme CRCstruct gebildet. Die übertragene Struktur-Checksumme CRC_{struct} und die erneut berechnete Struktur-Checksumme CRC_{struct} wird auf der Seite der zweiten Automatisierungskomponente 12, also auf der Seite des Empfängers 42 geprüft und bei einer Abweichung der Struktur-Checksummen voneinander wird eine Datenverfälschung erkannt.

Da nun gemäß FIG 4 der Empfänger 42 und der Sender 41 eine unterschiedliche Datenstruktur 20 aufweisen, haben die Telegramme damit unterschiedliche Checksummen CRC_{struct} bzw. unterschiedliche Startwerte und das Telegramm wird als nicht valide vom Empfänger angesehen und damit eine Datenverfälschung erkannt.

Gemäß FIG 5 ist ein Engineering-System E zum Anlegen und/oder Konfigurieren und/oder Überwachen einer fehlersicheren Kommunikationsverbindung 1 dargestellt.

Das Engineering-System E weist ein Zuordnungsmittel 31 auf, welche den Datentypen 21,22,23 einer Datenstruktur 20 Repräsentanten 30 zuordnen kann.

Über einen Zuordnungsschritt Verbindungsparameter "einschreiben" 32 werden in der Automatisierungsanlage 10 in der ersten und zweiten Automatisierungskomponente 11, 12 Zuordnungsinformationen der Repräsentanten 30 zu den Datentypen 21,22,23 gespeichert.

## Patentansprüche

1. Verfahren zur Erkennung von Datenverfälschungen bei einer Datenübertragung über eine fehlersichere Kommunikationsverbindung (1) zwischen einer ersten Automatisierungskomponente (11) und einer zweiten Automatisierungskomponente (12) der industriellen Steuerungstechnik, wobei bei einer Übertragung einer Datenstruktur (20) zur Absicherung der Datenstruktur (20) in einem zu übertragenden Telegramm sowohl auf der Seite der ersten Automatisierungskomponente (11) als auch auf der Seite der zweiten Automatisierungskomponente (12) eine Checksumme (CRC_{telegr}) über das Telegramm gebildet wird, die Datenstruktur (20) umfasst dabei unterschiedliche Datentypen (21,...,25),
**dadurch gekennzeichnet, dass** vor dem Bilden der Checksumme (CRC_{telegr}) für das Telegramm auf der Seite der ersten Automatisierungskomponente (11) den in der Datenstruktur (20) enthaltenen Datentypen (21,...,25) ein datentypspezifischer Repräsentant (30) zugeordnet wird, und anschließend über die Repräsentanten (30) eine Struktur-Checksumme (CRC_{struct}) gebildet wird, und dann die Datenstruktur (20) mit der über die Repräsentanten (30) gebildeten Struktur-Checksumme (CRC_{struct}) übertragen wird, wobei bei der zweiten Automatisierungskomponente (12) zu den in der empfangenen Datenstruktur (20) enthaltenen Datentypen (21,...,25) erneut der datentypspezifische Repräsentant (30) zugeordnet wird, und erneut über die Repräsentanten (30) die Struktur-Checksumme (CRC_{struct}) gebildet wird, die übertragene Struktur-Checksumme (CRC_{struct}) und die erneut berechnete Struktur-Checksumme (CRC_{struct}) wird auf der Seite der zweiten Automatisierungskomponente (12) geprüft und bei einer Abweichung der Struktur-Checksumme (CRC_{struct}) voneinander wird eine Datenverfälschung erkannt.

2. Verfahren nach Anspruch 1, wobei bei einer erkannten Datenverfälschung ein Datenübertragungsfehler in der Kommunikationsverbindung (1) erkannt wird und für die Kommunikationsverbindung (1) ein sicherer Zustand gewählt wird, wobei vorprojektierte Ersatzwerte in der zweiten Automatisierungskomponente (12) bereitgestellt werden.

3. Verfahren nach Anspruch 1 oder 2, wobei bei der Datenübertragung die über die Repräsentanten (30) gebildete Struktur-Checksumme (CRC_{struct}) zusätzlich zu der für das zu übertragene Telegramm gebildeten Checksumme (CRC_{telegr}) übertragen wird.

4. Verfahren nach einem der Ansprüche 1 bis 3, wobei als Repräsentant (30) ein numerischer Bezeichner, ein textueller Bezeichner oder auch der Datentypbezeichner selbst verwendet wird.

5. Verfahren nach einem der Ansprüche 1 bis 4, wobei zur Datenübertragung ein Sicherheitsprotokoll verwendet wird.

6. Engineering-System (E) zum Anlegen und/oder Konfigurieren und oder Überwachen einer fehlersicheres Kommunikationsverbindung (1) zwischen einer ersten Automatisierungskomponente (11) und einer zweiten Automatisierungskomponente (12) in einer Automatisierungsanlage (10) der industriellen Steuerungstechnik, wobei über die Kommunikationsverbindung (1) auch Datenstrukturen (21,..., 25) übertragbar sind,
wobei vorgesehen ist, dass bei einer Übertragung einer Datenstruktur (20) zur Absicherung der Datenstruktur (20) in einem zu übertragenden Telegramm sowohl auf der Seite der ersten Automatisierungskomponente (11) als auch auf der Seite der zweiten Automatisierungskomponente (12) eine Checksumme (CRC_{telegr}) über das Telegramm gebildet wird, und
wobei die Datenstrukturen (20) dabei unterschiedliche Datentypen (21,...,25) umfassen,
**dadurch gekennzeichnet, dass** ein Zuordnungsmittel (31) vorhanden ist, welches ausgelegt ist den Datentypen (21,...,25) einer Datenstruktur (20), welche einer angelegten fehlersicheren Kommunikationsverbindung (1) zugeordnet ist, jeweils einen datentypspezifischen Repräsentanten (30) zuzuordnen und diese Zuordnung als Zuordnungsinformation der ersten und zweiten Automatisierungskomponente (11,12) zu übergeben, welche zur Erkennung einer Datenverfälschung bei einer Datenübertragung über die fehlersichere Kommunikationsverbindung (1) zwischen der ersten Automatisierungskomponente (11) und der zweiten Automatisierungskomponente (12) über die Repräsentanten (30) eine Struktur-Checksumme (CRC_{struct}) bilden.

7. Engineering-System (E) nach Anspruch 6, ausgestaltet bei einer durch die Automatisierungskomponente (11,12) erkannten Datenverfälschung einen Eintrag in einen Diagnosepuffer zu veranlassen.

## Claims

1. Method for identifying data corruption in a data transfer over an error-proof communication link (1) between a first automation component (11) and a second automation component (12) in industrial control engineering, wherein, during transfer of a data structure (20), for the purpose of securing the data structure (20) in a telegram to be transferred, a checksum (CRC_{telegr}) regarding the telegram is formed both at the first automation component (11) and at the second automation component (12), wherein the data structure (20) includes different data types (21, ..., 25),
**characterised in that**, before the checksum (CRC_{telegr}) for the telegram is formed at the first automation component (11), there is associated with the data types (21, ..., 25) contained in the data structure (20) a data-type-specific representative (30), and then, by way of the representatives (30), a structure checksum (CRC_{struct}) is formed, and thereafter the data structure (20) with the structure checksum (CRC_{struct}) that is formed by way of the representatives (30) is transferred, wherein in the second automation component (12) the data-type-specific representative (30) is once again associated with the data types (21, ..., 25) in the received data structure (20), and the structure checksum (CRC_{struct}) is once again formed by way of the representatives (30), the transferred structure checksum (CRC_{struct}) and the newly calculated structure checksum (CRC_{struct}) are checked at the second automation component (12) and, in the event of a discrepancy between the structure checksums (CRC_{struct}), data corruption is identified.

2. Method according to claim 1, wherein, in the event of identification of data corruption, a data transfer error in the communication link (1) is identified, and a secure condition is selected for the communication link (1), wherein pre-projected substitute values are provided in the second automation component (12).

3. Method according to claim 1 or 2, wherein, during data transfer, the structure checksum (CRC_{struct}) that is formed by way of the representatives (30) is transferred in addition to the checksum (CRC_{telegr}) formed for the telegram to be transferred.

4. Method according to one of claims 1 to 3, wherein there is used as the representative (30) a numerical indicator, a textual indicator or indeed the data type indicator itself.

5. Method according to one of claims 1 to 4, wherein, for the purpose of data transfer, a security protocol is used.

6. Engineering system (E) for the setup and/or configuration and/or monitoring of an error-proof communication link (1) between a first automation component (11) and a second automation component (12) in an automation system (10) of industrial control engineering, wherein it is also possible to transfer data structures (21, ..., 25) over the communication link (1),
wherein it is provided that, during transfer of a data structure (20), for the purpose of securing the data structure (20) in a telegram to be transferred, a checksum (CRC_{telegr}) regarding the telegram is formed both at the first automation component (11) and at the second automation component (12), and
wherein the data structures (20) include different data types (21, ..., 25),
**characterised in that** there is provided an association device (31) that is embodied to associate with each of the data types (21, ..., 25) of a data structure (20) that is associated with a set-up error-proof communication link (1) a respective data-type-specific representative (30), and to transfer this association to the first and second automation component (11, 12) as an item of association information, wherein, for the purpose of identifying data corruption in a data transfer over the error-proof communication link (1) between the first automation component (11) and the second automation component (12), these form a structure checksum (CRC_{struct}) by way of the representatives (30) .

7. Engineering system (E) according to claim 6, embodied to trigger an entry in a diagnostic buffer if data corruption is identified by the automation component (11, 12).

## Revendications

1. Procédé de détection d'altérations de données dans une transmission de données par une liaison (1) de communication sécurisée à l'erreur entre un premier composant (11) d'automatisation et un deuxième composant (12) d'automatisation de la technique de commande industrielle, dans lequel lors d'une transmission d'une structure (20) de données, on forme pour la sécurisation de la structure (20) de données dans un télégramme à transmettre tant du côté du premier composant d'automatisation qu'également du côté du deuxième composant (12) d'automatisation une somme (CRC_{telegr}) de contrôle sur le télégramme, qui comprend la structure de données, ce faisant des types (21, ..., 25) de données différentes,
**caractérisé en ce que** avant de former la somme (CRC_{telegr}) de contrôle du télégramme du côté du premier composant (11) d'automatisation, on associe aux types (21, ..., 25) de données contenues dans la structure (20) de données un représentant (30) spécifique à un type de données et on forme ensuite par les représentants (30) une somme (CRC_{struct}) de contrôle de structure et on transmet ensuite la structure (20) de données avec la somme (CRC_{struct}) de contrôle de structure formée par les représentants (30), dans lequel dans le deuxième composant (12) d'automatisation, on associe à nouveau le représentant (30) spécifique à un type de données aux types (21, ..., 25) de données contenues dans la structure (20) de données reçues et on forme à nouveau par les représentants (30) la somme (CRC_{struct}) de contrôle de structure, on contrôle du côté du deuxième composant (12) d'automatisation la somme (CRC_{struct}) de contrôle de structure transmise et la somme (CRC_{struct}) de contrôle de structure calculée à nouveau et, s'il y a un écart entre les sommes (CRC_{struct}) de contrôle de structure, on détecte une altération de données.

2. Procédé suivant la revendication 1, dans lequel, si une altération de données est détectée, on détecte un défaut de transmission de données dans la liaison (1) de communication et on choisit pour la liaison (1) de communication un état sécurisé, dans lequel des valeurs de remplacement planifiées à l'avance sont mises à disposition dans le deuxième composant (12) d'automatisation.

3. Procédé suivant la revendication 1 ou 2, dans lequel lors de la transmission de données, on transmet la somme (CRC_{struct}) de contrôle de structure formée par les représentants (30) supplémentairement à la somme (CRC_{telegr}) de contrôle formée pour le télégramme transmis.

4. Procédé suivant l'une de revendications 1 à 3, dans lequel on utilise comme représentant (30) un indicateur numérique, un indicateur textuel ou également l'indicateur de type de données soi-même.

5. Procédé suivant l'une des revendications 1 à 4, dans lequel on utilise un protocole sécurisé pour la transmission de données.

6. Système (E) d'ingénierie pour l'établissement et/ou la configuration et/ou le contrôle d'une liaison (1) de communication sécurisée à l'erreur entre un premier composant (11) d'automatisation et un deuxième composant (12) d'automatisation dans une installation (10) d'automatisation de la technique de commande industrielle, dans lequel des structures (21, ..., 25) de données peuvent être transmises aussi par la liaison (1) de communication,
dans lequel il est prévu, lors d'une transmission d'une structure (20) de données pour la sécurisation de la structure (20) de données dans un télégramme à transmettre, de former à la fois du côté du premier composant (11) d'automatisation et du côté du deuxième composant (12) d'automatisation une somme (CRC_{telegr}) de contrôle sur le télégramme et
dans lequel les structures (20) de données comprennent des types (21, ..., 25) de données différents,
**caractérisé en ce qu'**il y a un moyen (31) d'association qui est conçu pour associer respectivement un représentant (30) spécifique à un type de données aux types (21, ..., 25) de données d'une structure (20) de données, qui est associée à une liaison (1) de communication établie sécurisée à l'erreur, et pour transmettre cette association comme information d'association au premier et au deuxième composant (11, 12) d'automatisation, laquelle, pour la détection d'une altération de données lors d'une transmission de données par la liaison (1) de communication sécurisée à l'erreur entre le premier composant (11) d'automatisation et le deuxième composant (12) d'automatisation, forme par les représentants (30) une somme (CRC_{struct}) de contrôle de la structure.

7. Système (E) d'ingénierie suivant la revendication 6, conformé pour si une altération de données est détectée par les composants (11, 12) d'automatisation, provoquer une entrée dans un tampon de diagnostic.
